(19) Europäisches Patentamt
European Patent Office
Office européen des brevets

(11) **EP 3 933 531 A1**

(12) **EUROPÄISCHE PATENTANMELDUNG**

(43) Veröffentlichungstag:
**05.01.2022 Patentblatt 2022/01**

(51) Int Cl.:
***G05B 23/02*** *(2006.01)*

(21) Anmeldenummer: **20183283.9**

(22) Anmeldetag: **30.06.2020**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Bierweiler, Thomas**
  **76131 Karlsruhe (DE)**
• **Labisch, Daniel**
  **76149 Karlsruhe (DE)**
• **Syla, Erion**
  **76137 Karlsruhe (DE)**

(54) **VERFAHREN UND SYSTEM ZUR FEHLERURSACHENANALYSE IN EINER PROZESSTECHNISCHEN ANLAGE**

(57) Zur Fehlerursachenanalyse in einer prozesstechnischen Anlage (1), werden Engineering-Informationen (18) der Anlage (1), welche Informationen über die Anlagenkomponenten und ihre Verschaltung in der Anlage (1) beinhalten, in digitaler Form bereitgestellt, um aus den Engineering-Informationen (18) ein Inferenzmodell (30) in Form eines probabilistischen physikalischen Modells der Anlage (1) mit Wahrscheinlichkeitsverteilungen und Priorvariablen zu erstellen. In einem Diagnosemodus (40) des Inferenzmodells (30) wird unter Verwendung von Messdaten aus der Anlage (1) eine Bayes'sche Inferenz von Fehlerwahrscheinlichkeiten durchgeführt.

FIG. 2

EP 3 933 531 A1

**Beschreibung**

Die Erfindung betrifft ein Verfahren zur Fehlerursachenanalyse in einer prozesstechnischen Anlage.

Die Erfindung betrifft ferner ein System zur Fehlerursachenanalyse in einer prozesstechnischen Anlage.

Die Automatisierungstechnik dient der Automatisierung von technischen Prozessen. Das automatisierte Gesamtsystem besteht aus einer Anlage, in der der Prozess abläuft, einem Automatisierungssystem und Bedienpersonal. Bei der Anlage kann es sich insbesondere um eine prozesstechnische oder verfahrenstechnische Anlage aus dem Bereich der chemischen Industrie, Getränke- und Lebensmitteltechnik, Umwelttechnik, Pharmaindustrie oder Gas- und Ölindustrie handeln.

Eine derartige (Industrie-)Anlage umfasst in der Regel eine Vielzahl von einzelnen, miteinander verschalteten Anlagenkomponenten. Typische Anlagenkomponenten einer verfahrens- bzw. prozesstechnischen Anlage sind Behälter, Reaktoren, Rohrleitungen, Armaturen usw., durch die z. B. bei einem Herstellungsprozess Ausgangsstoffe, insbesondere Fluide, laufen und dabei zu einem resultierenden Produkt verändert oder verarbeitet werden.

In der prozessnahen Feldebene des Automatisierungssystems führen örtlich verteilte, dezentrale Feldgeräte vorgegebene Funktionen im Rahmen der Anlagenautomatisierung aus und tauschen dabei prozess-, anlagen- und/oder geräterelevante Informationen mit Automatisierungskomponenten der übergeordneten Ebenen des Automatisierungssystems aus. Zu den Feldgeräten gehören Sensoren (Messumformer für, z. B. Füllstand, Durchfluss, Druck und Temperatur, Analysengeräte für Gas- oder Flüssigkeitsanalyse, Wägesysteme), die Prozessdaten in Form von Messwerten von Prozessgrößen übermitteln, und Aktoren (Stellantriebe, Stellungsregler für Ventile, sonstige dezentrale Regler und Frequenzumrichter für elektromotorische Antriebe von, z. B. Pumpen), die Prozessdaten in Form von Stelldaten erhalten, um den Prozess zu beeinflussen.

Es besteht das allgemeine Bedürfnis, die Wirtschaftlichkeit solcher Anlagen zu optimieren und Abweichungen der Werte einzelner Prozessgrößen von Sollwerten und damit vom Betriebspunkt der Anlage zu vermindern, um die Fahrweise der Anlage zu beruhigen, Qualitätsanforderungen besser einzuhalten oder den Prozess näher an seinen Grenzen zu betreiben und den Durchsatz zu steigern.

Gewisse kritische Abweichungen können jedoch nicht allein durch Regelungssysteme behoben werden, sondern benötigen zusätzliche Gegenmaßnahmen. Werden diese Fehler nicht rechtzeitig erkannt, kann dies zu einer schlechten Produktqualität oder sogar zu einem Ausfall von Analgenkomponenten, Anlagenteilen bis hin zur kompletten Anlage führen.

Eine automatisierte Fehlerdiagnose ermöglicht durch schnellere Erkennung der Fehlersituationen die rechtzeitige Einleitung von Gegenmaßnahmen, um damit Ausfallzeiten zu verkürzen oder sogar zu verhindern. Die Aufgabe der Fehlerdiagnose (Fault Detection and Isolation, FDI) umfasst zum einen die Detektion von Fehlern und zum anderen die Isolation einzelner Fehlertypen zur Eingrenzung der Fehlerursache.

Verfahren zur Fehlerdiagnose werden häufig in zwei Kategorien eingeteilt. Auf der einen Seite existieren prozessmodellbasierte Methoden, die die gemessenen Signale in ein mathematisches Modell einsetzen und Merkmalsgrößen berechnen. Im Gegensatz dazu stehen die signalbasierten, datengetriebenen Methoden, welche basierend auf historischen Daten ein Blackbox-Modell der Anlage erstellen oder Korrelationen analysieren [1, Seiten 5-6].

Modellbasierte Ansätze unterteilen sich in Zustandsschätzer wie erweiterte Kalman-Filter oder Unknown Input Observer (UIO), welche den wahrscheinlichsten Betriebs- oder Fehlerzustand im Zustandsraum schätzen, in Paritätsgleichungen, welche die analytische Redundanz durch zusätzliche Sensoren ausnutzen, um charakteristische Residualsignaturen zu generieren, oder in Parameterschätzungsmethoden, welche abweichende Parameterwerte bestimmen und jede Abweichung einer Fehlerquelle zuordnen [2, Seite 9].

Signalbasierte Methoden verfolgen verschiedene Ansätze. Für einfache Signale reichen Grenzwertprüfungen oder Schwingungssignalmodelle, welche Signale einzeln auf Abweichungen der Werte oder Frequenzen prüfen, wohingegen für komplexere Systeme statistische Klassifikationsmethoden oder künstliche Intelligenzen verwendet werden. Statische Methoden verringern die Ordnung des Systems mit Methoden wie Principal Component Analysis (PCA), indem sie die minimale Anzahl unabhängiger Komponenten bestimmen und danach eine Clusteranalyse durchführen. Algorithmen des maschinellen Lernens optimieren dagegen zahlreiche Parameter eines neuronalen Netzes oder Entscheidungsbaums auf aufgenommene Trainingsdaten [3, Seiten 41-43].

Die genannten Methoden geben nur einen Überblick über das Themengebiet, da die Literatur in diesem Gebiet insbesondere in den letzten Jahren viele unterschiedliche Ansätze verfolgt. Dabei hat sich bisher keine Methode gegenüber andern als überlegen erwiesen, weswegen weiterhin mit steigendem Trend in viele Richtungen geforscht wird [4, Seiten 4-5].

Modellbasierte Ansätze benötigen umfangreiche Systemverständnisse, welche bei verfahrenstechnischen Prozessen häufig nicht vorhanden sind. Die betrachteten Prozesse sind häufig nichtlinear, dynamisch, hybride und komplex, wodurch insbesondere bei industriellen Großanlagen nicht nur der Modellierungs-, sondern auch der Rechenaufwand enorm steigt [1.]. Daher können Lösungen aus anderen Bereichen nicht einfach übertragen werden. Ebenso verfälscht starkes Rauschen in Messungen die Ergebnisse.

Weil Prozesswissen häufig in Form von Messdaten vorhanden ist, werden in der Prozessindustrie häufiger datengetriebene Ansätze verfolgt. Besonders weit verbreitet sind dabei Principal Component Analysis (PCA) und Projection to Latent Structures (PLS) bei den statistischen Methoden [5, Seite 267] und Artificial Neural Networks (ANN) und Support Vector Machines (SVM) als Lernmethoden [6, Seiten 4-5]. Vorteile sind hier der sehr geringe Aufwand in der Umsetzung und die Nutzungsmöglichkeit als Komplettlösung vom Messwert bis zum Fehlertyp.

Häufig sind jedoch keine oder wenige Daten zu Fehlersituationen vorhanden, und Anlagenbetreiber möchten nicht ihre Anlage in kritische Situationen bringen, um diese Daten zu gewinnen. In dieser Situation scheitern rein signalbasierte Modelle, weil sie, selbst wenn sie einen unbekannten Fehler erkennen und ihn von den restlichen Fehlern unterscheiden können, nicht in der Lage sind, den Fehler einem konkreten Bauteil oder Fehlfunktionen zuzuordnen.

Der Erfindung liegt daher die Aufgabe zugrunde, in einem hybriden Ansatz modellbasierte und signalbasierte Methoden zu kombinieren, um ihre Vorteile zu maximieren und ihre Nachteile zu reduzieren.

Gemäß der Erfindung wird die Aufgabe durch das in Anspruch 1 angegebene Verfahren und das in Anspruch 5 angegebene System gelöst, von denen jeweils vorteilhafte Weiterbildungen in den Unteransprüchen angegeben sind.

Gegenstand der Erfindung ist somit ein Verfahren zur Fehlerursachenanalyse in einer prozesstechnischen Anlage, wobei Engineering-Informationen der Anlage, welche Informationen über die Anlagenkomponenten und ihre Verschaltung in der Anlage beinhalten, in digitaler Form bereitgestellt werden, aus den Engineering-Informationen ein Inferenzmodell in Form eines probabilistischen physikalischen Modells der Anlage mit Wahrscheinlichkeitsverteilungen und Priorvariablen erstellt wird und in einem Diagnosemodus des Inferenzmodells mit dem Inferenzmodell unter Verwendung von Messdaten aus der Anlage eine Bayes'sche Inferenz von Fehlerwahrscheinlichkeiten durchgeführt wird.

Gegenstand der Erfindung ist ferner ein System zur Fehlerursachenanalyse in einer prozesstechnischen Anlage mit einem Transformationsmodul, das dazu ausgebildet ist, aus Engineering-Informationen der Anlage, welche Informationen über die Anlagenkomponenten und ihre Verschaltung in der Anlage beinhalten, ein Inferenzmodell in Form eines probabilistischen physikalischen Modells der Anlage mit Wahrscheinlichkeitsverteilungen und Priorvariablen zu erstellen, und mit einem Inferenzmodul, das dazu ausgebildet ist, in einem Diagnosemodus des Inferenzmodells unter Verwendung von Messdaten aus der Anlage eine Bayes'sche Inferenz von Fehlerwahrscheinlichkeiten durchzuführen.

Engineering-Informationen bezeichnen hierbei Planungsdaten der prozesstechnischen Anlage sowie die Anlagenstruktur und Komponentendaten, welche in einer Anlagenplanungssoftware wie COMOS gespeichert sind oder aus Datenblättern gewonnen werden können. Bei den Engineering-Informationen kann es sich insbesondere um ein maschinenlesbares R&I-Fließschema (Rohrleitungs- und Instrumentierungsfließschema) handeln, das alle relevanten Komponenten der Anlage und der Automatisierung als graphische Objekte enthält.

In einem Trainingsmodus des Inferenzmodells können Schätzungen von Modellparametern, welche Prioren in dem Inferenzmodell darstellen, optimiert werden, indem unter Verwendung von Messdaten aus der Anlage eine Bayes'sche Inferenz des Inferenzmodells durchgeführt wird.

Das Inferenzmodell kann in vorteilhafter Weise mithilfe eines Bondgraphen aus den Engineering-Informationen erstellt werden. Bondgraphen eignen sich zur Analyse mechatronischer Systeme, da sie eine vereinheitlichte Darstellung mehrerer technischer Domänen liefern. Da prozesstechnischen Anlagen nicht nur aus hydraulischen Rohrsystemen und mechanischen Aktoren bestehen, sondern auch aus elektrischen Schaltkreisen und informationstechnischen Datenflüssen, ist eine solche Darstellung zur Identifikation verschiedenster Fehlertypen sehr vorteilhaft. Zusätzlich liefert die Bondgraphentheorie einen Formalismus zur Analyse des R&I-Fließschema, der in einem automatisiert ablaufenden System genutzt werden kann.

Aus den Engineering-Informationen der Anlage, insbesondere dem R&I-Fließschema, kann zunächst ein Metamodell der Anlage generiert werden, indem Templates einer Modellbibliothek übernommen werden, die zu jedem Komponententyp der Anlage den zu generierenden Code und Inferenzvariablen enthält, für die Bayes'sche Inferenz ausgeführt werden soll. Aus dem Metamodell kann dann beispielsweise durch eine rekursive Funktion das Inferenzmodell der Anlage erstellt werden.

Im Weiteren wird die Erfindung anhand von Ausführungsbeispielen und unter Bezugnahme auf die Figuren der Zeichnung erläutert; im Einzelnen zeigen

Fig. 1 ein Beispiel für eine technische Anlage in der Aktoren und Sensoren zusammenwirken,

Fig. 2 ein beispielhaftes Ablaufdiagramm für das erfindungsgemäße Verfahren,

Fig. 3 ein Klassendiagramm des Transformationsmoduls,

Fig. 4 einen schematisch vereinfachten Bondgraph mit Blockdiagramm,

Fig. 5 eine Anlagenstruktur des Metamodells,

Fig. 6       ein einfaches Beispiel eines Faktorgraphen,

Fig. 7       ein Klassendiagramm des Inferenzmoduls,

Fig. 8       Variablentypen der Basisklasse des Inferenzmoduls,

Fig. 9       ein Beispiel für die Modellprogrammierung,

Fig. 10      einen Faktorgraph der Anlage beim Training des Inferenzmodelle und

Fig. 11      den Faktorgraph bei der Fehlerursachendiagnose.

Gleiche Bezugszeichen haben in den verschiedenen Figuren die gleiche Bedeutung. Die Darstellungen sind rein schematisch und repräsentieren keine Größenverhältnisse.

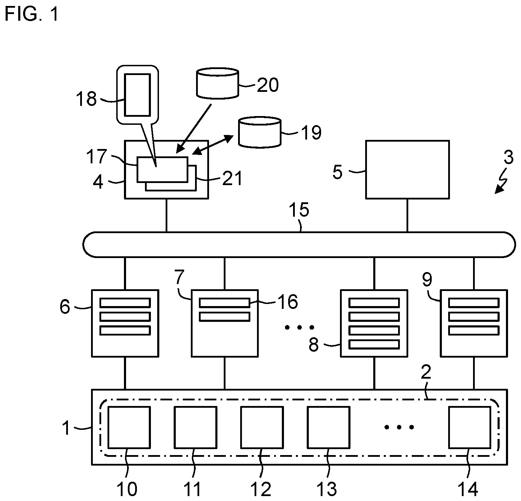

Fig. 1 zeigt in vereinfachter schematischer Darstellung ein Beispiel für eine prozesstechnische Anlage 1, in der ein Prozess 2 mittels eines Automatisierungssystems 3 gesteuert wird. Das Automatisierungssystem 3 enthält ein Planungs- und Engineering-System 4, ein Bedien- und Beobachtungssystem 5, eine Vielzahl von Automatisierungsgeräten 6, 7, 8, 9 und eine Vielzahl von Feldgeräten 10, 11, 12, 13, 14. Das Planungs- und Engineering-System 4, das Bedien- und Beobachtungssystem 5 und die Automatisierungsgeräte 6, 7, 8, 9 sind über ein Bussystem 15 miteinander verbunden. Die Feldgeräte 10, 11, 12, 13, 14 sind auf unterschiedliche Weise, z. B. unmittelbar, über Feldbusse oder eine dezentrale Peripherie an den Automatisierungsgeräten 6, 7, 8, 9 angeschlossen und nehmen in dem Prozess 1 vorgegebene Mess-, Steuer- und Regelungsfunktionen wahr, indem sie als Sensoren Messwerte von Prozessgrößen erfassen und als Aktoren durch Stelleingriffe auf den Prozess einwirken. Typische Sensoren sind Messumformer für Füllstand, Durchfluss, Druck und Temperatur, Analysengeräte für Gas- oder Flüssigkeitsanalyse und Wägesysteme. Typische Aktoren sind Stellantriebe, Stellungsregler für Ventile, sonstige dezentrale Regler und Frequenzumrichter für elektromotorische Antriebe von, z. B., Pumpen, Heizungen, Kühlungen usw. Die Automatisierungsgeräte 6, 7, 8, 9 greifen schreibend und lesend auf die Feldgeräte 10, 11, 12, 13, 14 zu und steuern dabei den Prozess 2 nach Maßgabe eines Steuerprogramms, das aus einer Vielzahl von in Wechselwirkung stehenden und über die Automatisierungsgeräte verteilten Automatisierungs-Funktionsbausteinen 16 besteht.

Das Planungs- und Engineering-System 4 enthält ein Planungs- und Engineering-Software-Tool 17, z. B. COMOS der Siemens AG, mittels dessen ein maschinenlesbares R&I-Fließschema (Rohrleitungs- und Instrumentierungsfließschema) 18 erstellt wird, in dem alle relevanten Komponenten der Anlage 1 und der Automatisierung als graphische Objekte erkennbar sind. Die Eigenschaften der Objekte sind in Form von Attributen in einer Datenbank 19 abgelegt, ebenso wie Verbindungen zwischen Objekten in Form von Materialflüssen (z. B. Rohrleitungen) und Signalflüssen (z. B. Messwerte). Weiterhin werden in einem Archiv 20 (z. B. Cloud) historische oder simulierte Messdaten aus dem Produktionsbetrieb der Anlage 1 für den Normalfall und für bekannte Fehlerfälle bereitgestellt.

Zur Fehlerursachenanalyse in der prozesstechnischen Anlage 1 erstellt ein Software-Tool 21 aus den vorhandenen Engineering-Informationen der Anlage 1, also den Planungsdaten der sowie der Anlagenstruktur und Komponentendaten, welche in der Anlagenplanungssoftware gespeichert sind oder aus Datenblättern gewonnen werden können, automatisiert ein diagnosefähiges probabilistisches Modell (Inferenzmodell) der Anlage 1. Das Inferenzmodell ermöglicht es, durch Ausführung Bayes'scher Inferenz anhand von Anlagenmessdaten die Auftrittswahrscheinlichkeiten einzelner Fehlerursachen zu bestimmen und fehlerbehaftete Anlagenteile oder -komponenten zu identifizieren. Das Software-Tool 21 ist hier Bestandteil des Planungs- und Engineering-Systems 4, aber auch in einem separaten System ablaufen kann.

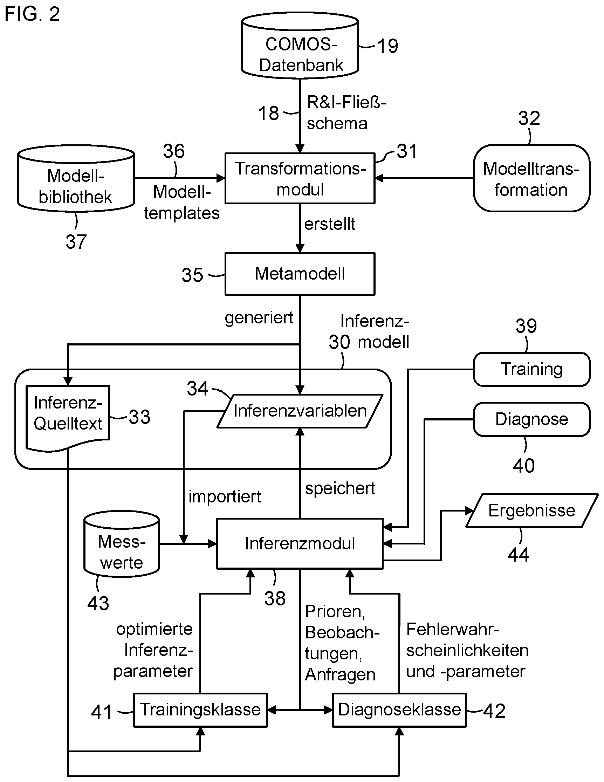

In Fig. 2 ist beispielhaft der grundsätzliche Ablauf des erfindungsgemäßen Verfahrens zu Fehlerursachenanalyse in einem Flussdiagramm dargestellt. Das Verfahren besteht aus einer Transformationsphase, in der das oben erwähnte Inferenzmodell 30 erstellt wird, und einer Inferenzphase, in der Bayes'sche Inferenz durchgeführt wird, um zum einen das Inferenzmodell zu trainieren und zum anderen die Auftrittswahrscheinlichkeiten einzelner Fehlerursachen in der Anlage 1 zu bestimmen und fehlerhafte Anlagenteile und -komponenten zu identifizieren.

In der Transformationsphase führt ein Transformationsmodul 31 eine Modelltransformation 32 des R&I-Fließschemas 18 der Anlage 1 in das Inferenzmodell 30 mit für die Inferenz benötigtem Quelltext 33 und Variablenwerten 34 aus. Dabei liest das Transformationsmodul 31 das in der COMOS-Datenbank 19 gespeicherte R&I-Fließschema 18 aus und generiert zunächst ein Metamodell 35 der Anlage 1, indem es Templates 36 einer Modellbibliothek 37 übernimmt. Die Templates 36 beschreiben das Verhalten einzelner Komponenten (z. B. Pumpe, Ventil, Tank, Rohr usw.) der Anlage 1 und beinhalten mögliche Fehlerursachen (z. B. Leckage, Verstopfung, verringerte Pumpenleistung usw.). Die Modellbibliothek 37 enthält zu jedem Komponententyp den zu generierenden Code und die notwendigen Inferenzvariablen, also die Variablen, für die die Bayes'sche Inferenz ausgeführt werden soll, so dass aus dem Metamodell 35 das Inferenzmodell 30 der Anlage 1 generiert werden kann. Grundsätzlich kann der Inferenzcode auch direkt und ohne den Zwischenschritt der Erstellung eines Metamodells generiert werden.

Die Inferenz wird in einem eigenen Inferenzmodul 38 ausgeführt und kann dazu z. B. auf die Funktionen des Infer.NET-Frameworks zugreifen. Infer.NET ist ein in C# geschriebenes open-source Framework mit einer Interferenz-Engine ("InferenceEngine"), die mehrere Algorithmen zur Ausführung von Inferenz beinhaltet. Das Grundprinzip der Inferenz basiert auf dem Satz von Bayes:

$$P(A|B) = [P(B|A) \cdot P(A)] / P(B)$$

A und B seien die Ereignisse, die den Zufallsvariablen im obigen Faktorgraphen zugeordnet sind. B sei hierbei eine beobachtbare Wirkung und A sei eine verdeckte Ursache, dessen genaue Wahrscheinlichkeit unbekannt ist. P(A) sei daher nur eine A-priori-Schätzung der gesuchten Wahrscheinlichkeit, weswegen P(A) Priorwahrscheinlichkeit genannt wird. P(B) ist die Wahrscheinlichkeit des Auftretens der Beobachtung B, die durch wiederholte Experimente bestimmt werden kann. P(B|A) ist die bedingte Wahrscheinlichkeit, dass B beobachtet wird, wenn A eingetreten ist. P(B|A) ist daher der Faktor im Faktorgraphen, der den Zusammenhang zwischen A und B festlegt. Das Ergebnis P(A|B) ist die bedingte Wahrscheinlichkeit, dass A eingetreten ist, wenn B beobachtet wird. P(A|B) gilt nach einer Beobachtung als verbesserte Schätzung von P(A), weswegen es als A-posteriori- oder Posteriorwahrscheinlichkeit bezeichnet wird. Je mehr Beobachtungen gemacht werden, desto mehr nähert sich die Posteriorwahrscheinlichkeit der tatsächlichen Auftrittswahrscheinlichkeit der Ursache A an. In der Fehlerdiagnose kann mithilfe der höchsten Auftrittswahrscheinlichkeit auf die wahrscheinlichste Fehlerursache geschlossen werden.

Das Inferenzmodul 38 besitzt zwei Operationsmodi, Training 39 und Diagnose 40, die in zwei verwandten Klassen, Trainingsklasse 41 und Diagnoseklasse 42 implementiert sind. Für beide Operationsmodi müssen zunächst historische Messwerte 43, der Inferenzquelltext 32 und die Inferenzvariablen 33 importiert und in passender Form an die jeweilige Klasse weitergegeben werden. Die Trainingsklasse 41 nutzt die Messwerte 43, um die Schätzungen von Modellparametern (Inferenzparameter)des Inferenzmodells 31, welche Prioren (A-priori-Verteilungen) darstellen, zu optimieren. Diese werden wieder in dem Inferenzmodell 30 abgespeichert, was der Grund dafür ist, dass die Inferenzvariablen 34 und der Inferenzquelltext 33 getrennt gelagert sind. In der Diagnose 40 wird stattdessen eine Inferenz der Fehlerwahrscheinlichkeiten und -parameter durchgeführt. Die Ergebnisse 44 werden entweder ausgegeben oder zur Weiterverarbeitung abgespeichert.

Automatisch ist nur die Diagnose der in den Templates 36 definierten Fehlerursachen einzelner Komponenten möglich. Alternativ können auch an dem Inferenzmodell 30 weitere komplexere Fehlerursachen, die sich nicht nur auf eine Komponente auswirken, ergänzt werden, wozu jedoch das Gesamtmodell der Anlage 1 analysiert werden muss.

Im Folgenden wird die automatische Modelltransformation durch das Transformationsmodul 31 näher erläutert.

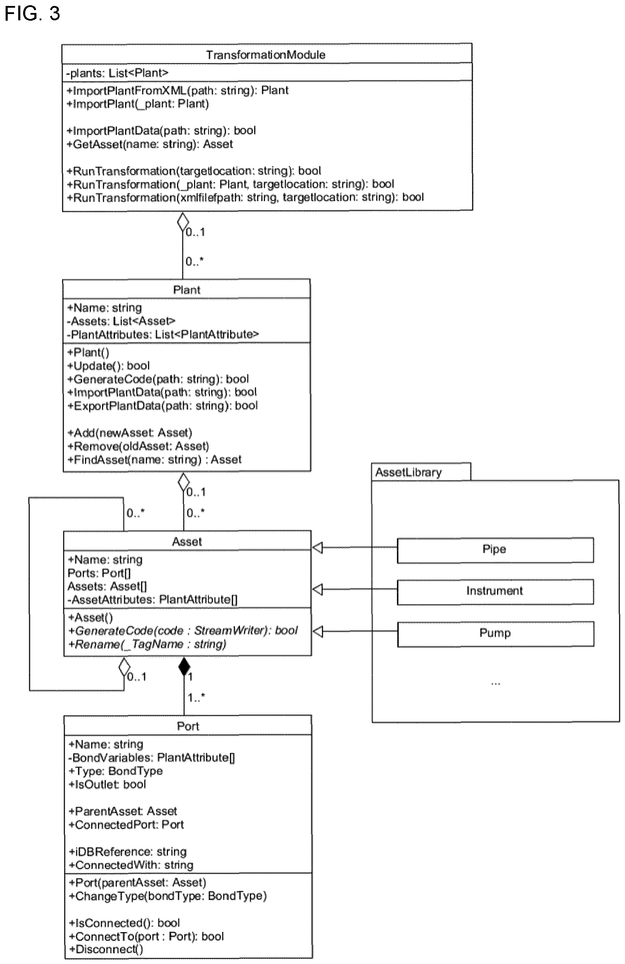

Die Modelltransformation 32 wird nur einmalig zur Übersetzung der Anlagenstruktur 18 benötigt und wird daher getrennt von der Fehlerursachenanalyse 39, 40 offline durchgeführt. Fig. 3 zeigt beispielhaft das Klassendiagramm des Transformationsmoduls 31. Die Transformation besteht aus einer Klasse "TransformationModule" zur Kapselung und den Metamodellklassen "Plant", "Asset" und "Port" für die Anlage 1, die Komponenten der Anlage und ihre Anschlüsse. in einer davon getrennten "AssetLibrary" (Modellbibliothek 37) sind die Komponentenklassen einzelner Bauteile wie Rohrleitungen, Prozessinstrumentierung, Pumpen usw. gesammelt.

Die Struktur des von dem Transformationsmodul 31 erstellten Metamodells 35 soll die Struktur des R&I-Fließschemas 18 soweit wie möglich nachbilden, damit die Transformation in das Inferenzmodell 30 vereinfacht wird. Während die durch XML-Export aus der COMOS-Datenbank 19 entnommenen Elemente nur Attribute besitzen, enthalten die Klassen des Metamodells 35 zusätzlich Methoden zur Codegenerierung und Modelltransformation. Die Attribute des Metamodells 35 sind zudem speziell auf die Verwendung als Inferenzvariablen angepasst.

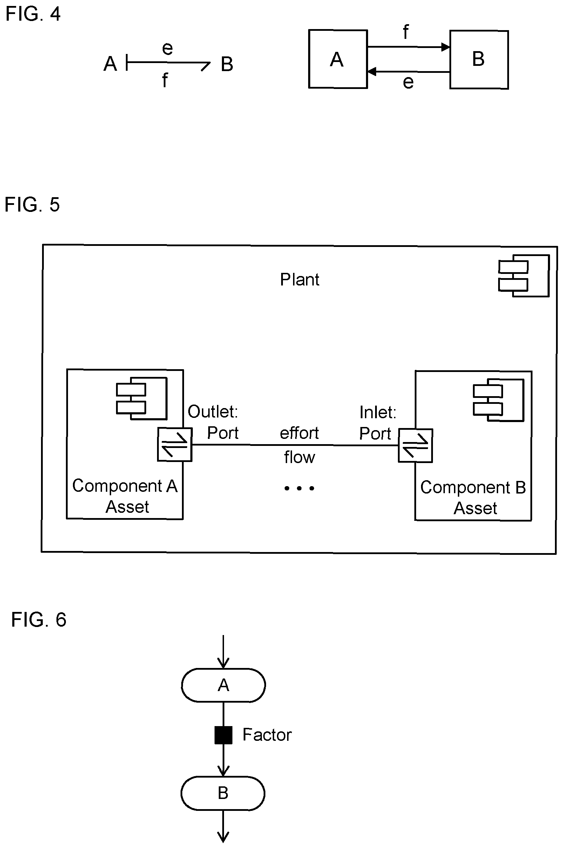

Während in dem R&I-Fließschema 18 Verknüpfungen zwischen den Komponenten primär zur graphischen Darstellung und nicht zum Informationsaustausch dienen, benötigt das Metamodell 35 für die Generierung des Inferenzmodells 30 die Verknüpfungen, um Inferenzgrößen auszutauschen. Dabei werden die Verbindungen nach der Bondgraphentheorie als bidirektionale Bonds angesehen, über die eine beliebige Anzahl an Größen ausgetauscht werden können. Bei Bondgraphen handelt es sich um gerichtete Graphen, die zur Simulation von Energieflüssen verwendet werden können. Wie Fig. 4 anhand eines schematisch vereinfachten Bondgraphs (links) mit Blockdiagramm (rechts) zeigt, repräsentieren die Knoten des Graphen repräsentieren Komponenten A, B der Anlage und die Kanten definieren Energieflüsse durch Angabe einer Potenzialvariable e (Ursache oder effort) und einer Flussvariable f (Wirkung oder flow), die miteinander multiplikativ verknüpft sind. Der Halbpfeil gibt die Richtung des Energieflusses e · f an.

Das Metamodell 35 überprüft die Energieflussrichtung und den Typ des Bonds, wobei sichergestellt wird, dass nur Ports desselben Typs und Ausgänge nur mit Eingängen verbunden werden können, damit es nicht zu Fehldiagnosen kommt. Mithilfe verschiedener Methoden der Metamodell-Klassen können im Anschluss die übersetzten Assets (Komponenten) zur Anlage hinzugefügt oder entfernt werden; Ports können miteinander verbunden oder getrennt werden. Dadurch ergibt sich beispielsweise die in Fig. 5 dargestellte Anlagenstruktur des Metamodells 35 der Anlage 1.

"Plant", "Asset" und "Port" besitzen jeweils eine Sammlung von Anlagenattributen, welche gleichzeitig in Inferenzvariablen umgewandelt werden können. Die Anlagenattribute umfassen die physikalischen und/oder geometrischen Daten der Anlage 1, einzelnen Komponenten und verarbeiteten Stoffe, die Messgrößen, Fehlersituationen sowie Variablen, die allein für die Inferenz benötigt werden. Zur Codegenerierung erhält die Komponentenklasse eine rekursive Methode, die die in der Modellbibliothek 37 enthaltenen Assets abläuft und zu jedem den entsprechenden Code mithilfe der Templates 36 erstellt. Nach Ausführung der Methode existiert die Quelltextdatei 33, die in das Inferenzmodul 38 eingebunden wird und das anlagenspezifische Inferenzmodell 30 beinhaltet. Nach der Codegenerierung wird die Liste aller gesammelter Anlagenattribute (Inferenzvariablen) sortiert und in eine eigene Datei 34 exportiert.

Bei den Variablen handelt es sich um mathematische Zufallsvariablen der Datentypen wie bool, int und double, je nachdem, ob es sich um eine Schaltvariable mit zwei Werten, eine diskrete (Ganzzahl-) Variable oder eine kontinuierliche (Fließkommazahl-) Zufallsvariable handelt. Zu jedem Wertebereich oder Wert, den eine Variable annehmen darf, existiert eine zugeordnete Wahrscheinlichkeitsverteilung. Mögliche Wahrscheinlichkeitsverteilung sind z. B. Gauß- oder Normalverteilung für kontinuierliche Variablen wie viele Messgrößen, Bernoulli-Verteilung für boolesche Variablen, die nur die zwei Werte annehmen können, und Beta-Verteilung für Modellierung von Wahrscheinlichkeiten wie z. B. Fehlerwahrscheinlichkeiten, die selbst Zufallsvariablen mit Verteilungsfunktion darstellen. In dem Inferenzmodell 30 sind die Zufallsvariablen über Ursache-Wirkungs-Zusammenhänge oder Korrelationen miteinander verknüpft, für deren Darstellung Faktorgraphen verwendet werden können. Der in Fig. 6 beispielhaft gezeigte Faktorgraph stellt eine Codezeile der Form B = Factor(A) dar, in der der Zufallsvariable B das Ergebnis der Operation Factor auf die Zufallsvariable A zugewiesen wird.

Wie oben bereits erwähnt, wird die Inferenz in dem Inferenzmodul 38 ausgeführt, wobei auf die Funktionen des Infer.NET-Frameworks zugegriffen wird. Zu diesem Zweck führt das Inferenzmodul 38 automatisch eine Abbildung des Inferenzmodells 30 in einen Faktorgraph der Anlage 1 durch.

Im Folgenden wird das Inferenzmodul 38 näher erläutert.

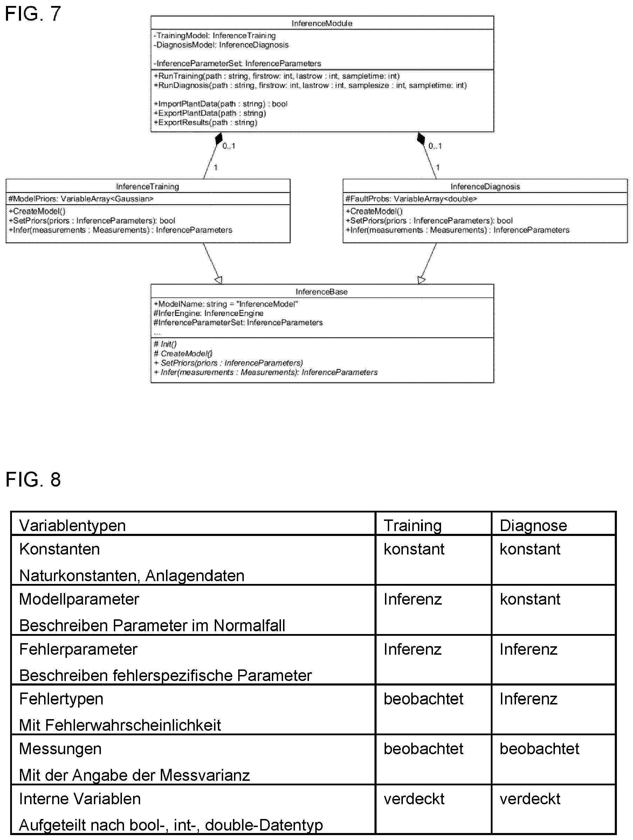

Das Inferenzmodul 38 dient als Startpunkt für die Fehlerursachenanalyse. Das Training des Inferenzmodells 30 und die Ausführung der Diagnose 40 können beliebig häufig offline oder online durchgeführt werden, weshalb durch die vorher einmalig ausgeführte Generierung des fertigen Inferenzmodells 30 Overhead vermieden wird. Das Inferenzmodul 38 besteht grundsätzlich aus vier Klassen, die in einem Klassendiagramm in Fig. 7 ausführlich dargestellt sind. Eine Klasse "InferenceModule" dient zur Kapselung aller genutzten Funktionen und speichert die Inferenzvariablen. Eine Basisklasse "InferenceBase", die den Kern des Inferenzmoduls 38 bildet und auf deren Funktion alle anderen Klassen aufbauen, beinhaltet sämtliche Inferenzmethoden sowie die Modelldefinition. Eine Diagnoseklasse "InferenceDiagnosis" und eine Trainingsklasse "InferenceTraining" erben von dieser Klasse und besitzen nur wenige Änderungen zur Anpassung an ihre jeweilige Aufgabe.

Die Basisklasse beinhaltet die vier Methoden Init(), CreateModel(), SetPriors() und Infer(), welche in dieser Reihenfolge ausgeführt werden.

Die Init()-Methode initialisiert die benötigten Variablen und die Inferenz-Engine von Infer.NET. In dem Modell werden mehrere Variablentypen definiert, die verschiedene Aufgaben erfüllen und die in Fig. 8 aufgelistet sind. Jeder der Variablentypen besitzt eine unterschiedliche Funktion in Training und Diagnose.

Konstanten bleiben beispielsweise in beiden Fällen konstant und beinhalten Naturkonstanten und Anlagenparameter, die für einen Inferenzlauf festgelegt werden.

Modellparameter sind Koeffizienten einprogrammierter mathematischer Formeln, die für die Beschreibung des Normalbetriebs der Anlage 1 benötigt werden und für diese charakteristisch sind. Diese Parameter können entweder eine physikalische Bedeutung besitzen und damit theoretisch berechenbar sein, oder aber sie besitzen keine physikalische Bedeutung und dienen nur als Freiheitsgrad. Infer.NET ist in der Lage, unabhängig von der Modellierungsart Inferenz durchzuführen und kann daher auch als Machine-Learning-Methode benutzt werden. Insbesondere im letzten Fall kann ein Training mit vorhandenen Messdaten notwendig sein, da die Startwerte meist zufällig ausgewählt werden und daher zunächst schlechte Ergebnisse liefern. Inferenz optimiert im Training die vorhandenen Schätzungen der Parameter, sodass diese nach dem Training das Anlagenverhalten besser wiedergeben. Im Falle bereits bestimmter Parameter kann gegebenenfalls auf das Training verzichtet werden, wenn das Vertrauen in diese Parameter hoch genug ist. Die Bedeutung der Modellparameter kann vom Programmierer frei gewählt werden und hat keinen Einfluss auf die Inferenz selbst.

Die Fehlerparameter beschreiben im Gegensatz zu den Modellparametern fehlerspezifische Koeffizienten. Da im Realfall ein und derselbe Fehler unterschiedliche Ausmaße besitzen kann, ist es sinnvoll, für diese Parameter Inferenz sowohl im Training als auch in der Diagnose auszuführen. Modellparameter sollten dagegen in der Diagnosephase konstant gehalten werden.

Jeder Fehlertyp, der erkannt werden soll, besitzt eine eigene Variable und Modellierung. Fehlertypen, die nicht modelliert werden, können während der Diagnose nicht erkannt werden und werden wahrscheinlich als Kombination anderer Fehlertypen interpretiert. Jeder Fehlertyp besitzt eine Wahrscheinlichkeit, die nur in der Diagnosephase berechnet wird. In der Trainingsphase werden die Fehler als beobachtete Eingangsgröße an das System weitergegeben, weil bei historischen Daten die aufgetretenen Fehler bekannt sein sollten. Andernfalls müssen diese Daten diagnostiziert werden.

Messungen werden sowohl im Training als auch in der Diagnose als beobachtete Größen eingegeben. Zudem sollte zu jedem Messwert eine Messungenauigkeit bekannt sein, damit in dem Modell zu jeder Messung eine gaußverteilte Zufallsvariable mit der richtigen Varianz bestimmt werden kann.

Bei den internen Variablen handelt es sich um Zwischengrößen, in Form von Schaltvariablen, Ganzzahl- oder Fließkommazahlvariablen oder (bool, int, double). Diese Variablen werden als Zwischenergebnisse oder verdeckte Variablen innerhalb des Modells benötigt und der Nutzer besitzt keinen direkten Zugriff auf diese. Sie werden während der Inferenz als variabel angesehen, aber es werden keine Ergebnisverteilungen zurückgegeben.

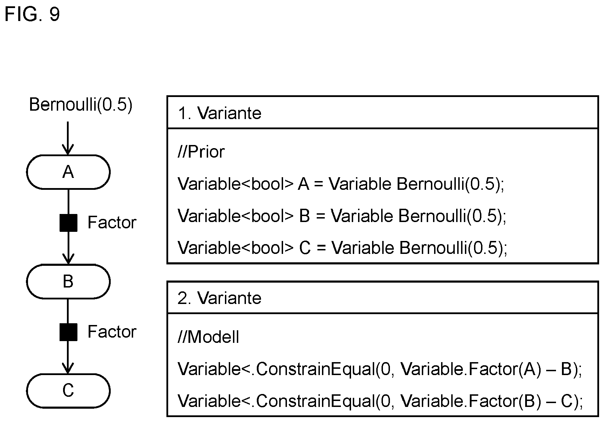

Nach der Initialisierung in Init() findet in der CreateModel()-Methode der Basisklasse die Modelldefinition statt, wobei der Faktorgraph der Anlage 1 erstellt wird. Die Modelldefinition kann in einer separaten Quelltextdatei entweder fest einprogrammiert oder, wie weiter oben bereits erläutert, durch das Transformationsmodul 31 erstellt werden. Die Quelltextdatei 33 kann ausgetauscht werden, um verschiedene Modelle zu implementieren. Bei der Modellierung sind zwei Vorgehensweisen denkbar, die beispielhaft in Fig. 9 dargestellt sind.

Bei der ersten Variante erhält nur die boolesche Variable A die Priorverteilung Bernoulli(0.5). Der Variablen B wird im Anschluss das Ergebnis der Operation Factor auf die Variable A zugewiesen. C wird das Ergebnis des Faktors von B zugewiesen. Dies ähnelt der klassischen Programmierung, allerdings erlaubt Infer.NET im Vergleich dazu, dass mit dieser Definition A berechnet werden kann, wenn C beobachtet wird. Wenn die Verhältnisse zwischen A und C nur eine mögliche Lösung zulassen, hat der Prior kaum Einfluss auf A in diesem Fall. In der zweiten Variante wird diese Eigenschaft der Programmierung stärker genutzt. A, B und C erhalten dieselbe Priorverteilung, damit kein Bias für eine bestimmte Lösung existiert. In der Modelldefinition wird dann festgelegt, dass das Ergebnis der Operation Factor(A)-B null ergibt, in der darauffolgenden Zeile wird analog dieselbe Bedingung für C festgelegt. Diese Darstellung ist für die Inferenz-Engine äquivalent zur ersten Variante und führt in beiden Fällen für beide Richtungen zu ähnlichen Ergebnissen. In der zweiten Variante können jedoch im Unterschied zur ersten Variante die Zeilen vertauscht werden, was einen enormen Vorteil für Modelltransformationen darstellt, weil dadurch die Komponenten der Anlage in beliebiger Reihenfolge ihren Code anhängen können und kein spezieller Algorithmus zum Ablaufen der Anlage festgelegt werden muss.

In der SetPriors()-Methode werden alle Priorverteilungen gesetzt, die auf vergangenen Trainingsdurchläufen oder Anlagendaten beruhen. Die Tabelle in Fig. 8 gibt an, in welcher Phase welche Parameter zugewiesen werden. Mit "konstant" markierte Typen werden in der SetPriors()-Methode als Beobachtung erklärt, da beobachtete Variablen während der Inferenz zu Konstanten werden (vgl. 2.3.3). Die Markierung als "beobachtet" bedeutet, dass solche Variablen erst kurz vor der Inferenzanfrage in der Infer()-Methode in das System eingegeben werden. Diese Variablentypen werden bei jedem Infer()-Aufruf neu beobachtet, während die in SetPriors() festgelegten Konstanten bei jeder Inferenzanfrage gleich bleiben, also eine konstante Beobachtung liefern. SetPriors() setzt zusätzlich die Priorverteilungen der Modell- und Fehlerparameter auf die Gaußverteilungen, die aus den Anlagenattributen erstellt wurden, und setzt die Präzisionsparameter.

Viele Aufgaben des Inferenzmoduls 38 sind in der Basisklasse implementiert. In der Phase der Priorzuweisung und Modellerstellung weichen Training und Diagnose jedoch voneinander ab, weshalb jede ihre eigene CreateModel()- und SetPriors()-Methode implementiert. Zu Beginn von CreateModel() wird jeweils die Initialisierungsmethode der Basisklasse ausgeführt, danach werden eigene Variablen initialisiert und Priorverteilungen zugewiesen. Zum Schluss wird die CreateModel()-Methode der Basisklasse ausgeführt. Zusätzlich zu den ModelParameter- und FaultParameter-Arrays existieren in der Trainingsklasse das ModelPriors-, in der Basisklasse das FaultPrior- und in der Diagnoseklasse das FaultProbs-Array. Die Gründe für diese Aufteilung liegen in Tabelle gemäß Fig. 8. Fehlerwahrscheinlichkeiten existieren nur während der Diagnose, da das Auftreten der Fehler in der Trainingsphase beobachtet wird. Eine Inferenz der Fehlerwahrscheinlichkeiten während des Trainings würde nur die relative Häufigkeit der Fehler während des Trainings wiedergeben. Diese ist aber nicht von Interesse, weswegen für das Training keine Wahrscheinlichkeiten bestimmt werden. Ebenso existieren Priorverteilungen für die Modellparameter nur in der Trainingsphase, da die Modellparameter in der Diagnosephase festgelegt werden. Priorverteilungen für Fehlerparameter werden in beiden Phasen benötigt, weshalb Inferenz für diese Parameter in der Basisklasse ausgeführt wird.

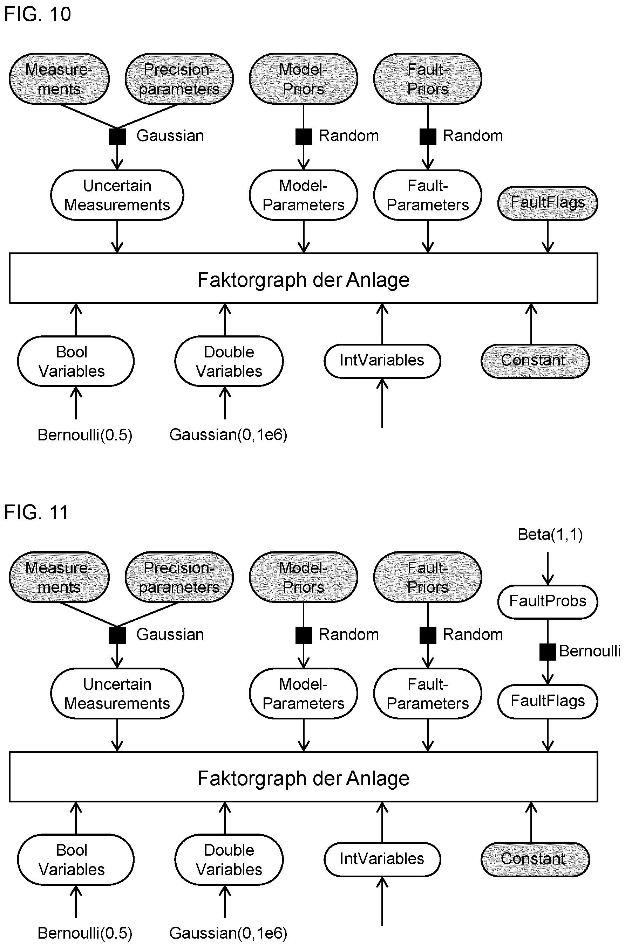

Fig. 10 zeigt den Faktorgraph der Anlage 1 beim Training. Beobachtete Variablen sind grau markiert, während sich Werte der weiß markierten Variablen während der Inferenz ändern können. Jede Größe in diesem Faktorgraphen steht stellvertretend für ein Array aus Variablen desselben Typs. Aus den Prioren der Modell- und Fehlerparameter werden mithilfe von Variable.Random Zufallsvariablen erstellt, die sich zwar an den Werten der Prioren orientieren, jedoch vom Algorithmus frei angepasst werden können. Die beobachteten Fehler werden als FaultFlags in das Modell eingegeben. Aufgetretene Fehler erhalten den Wert true, nicht aufgetretene den Wert false. Der Faktorgraph der Anlage wird in der CreateModel()-Methode der Basisklasse erstellt, welche den von dem Transformationsmodul 31 erstellten Inferenzcode beinhaltet. Dieser Code darf nur auf die hier definierten Variablen zugreifen, weswegen die Anlagenattribute im Metamodell 35 einen festen Variablentyp zugewiesen bekommen und keine neuen eigenen Variablen erstellen.

Fig. 11 zeigt den Faktorgraph der Anlage 1 bei der Diagnose, während der die Modellparameter im Gegensatz zum Training beobachtet werden und nicht von der Inferenz-Engine angepasst werden können. Dagegen erhalten Fehler eine eigene Modellierung. Diese werden als Bernoulli-verteilte Zufallsvariablen mit den Wahrscheinlichkeiten FaultProbs betrachtet. Die Wahrscheinlichkeiten selbst werden, wie weiter oben schon erläutert, als Beta-verteilt festgelegt und erhalten einen festen Prior. Da Fehlerwahrscheinlichkeiten nur für einen Zeitausschnitt bestimmt werden sollen und nicht für eine gesamte Historie, werden z. B. vor jeder Diagnose alle Wahrscheinlichkeiten zurückgesetzt und die Inferenz-Engine wird stattdessen dafür genutzt, diese Wahrscheinlichkeiten in die eine oder andere Richtung zu korrigieren. Aus der Korrekturdifferenz innerhalb des Zeitintervalls lässt sich auf die Fehlersituation schließen. Deswegen ist es sinnvoll, dass alle Wahrscheinlichkeiten zunächst als gleichverteilt betrachtet werden, um diese Änderung zu registrieren. Je stärker dann die Korrektur in Richtung 0 oder 1 ist, desto sicherer ist die Aussage, ob ein Fehler aufgetreten ist oder nicht. Bleibt eine Wahrscheinlichkeit bei 0,5 stehen, so kann die Engine keine Aussage über diesen Fehler treffen oder die Existenz dieses Fehlers hat keine Auswirkungen auf die gemachten Beobachtungen.

Die Infer()-Methode führt die Inferenz des Inferenzmodells 30 aus. Als Übergabe erhält diese Methode eine Datenstruktur mit den Messungen und Zeitstempeln. Die Werte der Messungen, die Abtastzeit und die Anzahl der Messungen werden als Beobachtungen der entsprechenden Modellvariablen eingegeben. Im Trainingsfall werden zusätzlich die aufgetretenen Fehler beobachtet. Die Basisklasse "InferenceBase" führt die Inferenz für die Fehlerparameter, die Trainingsklasse für die Modellparameter und die Diagnoseklasse für die Fehlerwahrscheinlichkeiten aus. Danach werden die Ergebnisse als InferenceParameterSet zurückgegeben. Nach dem Training werden die optimierten Parameter in der Variablendatenbank 24 abgespeichert.

Bei der Diagnose werden die Wahrscheinlichkeiten für alle Fehlerursachen neu geschätzt. Alle Fehlerursachen, deren Wahrscheinlichkeiten sich signifikant vergrößern, kommen dabei als tatsächliche Ursache in Frage. Da es häufig sehr viele Ursachen und im Vergleich nur wenige Messgrößen gibt, kommt es im Allgemeinen zur Ausgabe mehrerer Ursachen, was durchaus sinnvoll ist. Nach der Diagnose werden die Ergebnisse 44 entweder über die Konsole ausgegeben oder in einem Tabellenformat exportiert.

Das erfindungsgemäße Verfahren besitzt mehrere Vorteile, da es modellbasierte und signalbasierte Diagnoseverfahren vereint. So verlangen modellbasierte Verfahren eine hohe Modellgüte, die in komplexen Prozessanlagen schwer erreicht werden kann. Ebenso ist oft eine sehr hohe Messgenauigkeit notwendig, welche die Kosten erhöht und ein Grund ist, weshalb die Ergebnisse dieser Verfahren bei ungenauen Messwerten fehlerhaft sind. Der Modellierungsaufwand ist bei dem erfindungsgemäßen Verfahren vergleichsweise gering und kann durch Trainingsdaten oder Änderung der Modellierung noch weiter verringert werden. Probabilistisches Programmieren erlaubt es, dass die Messungenauigkeit unter geringem Aufwand bei der Diagnose miteinbezogen wird und damit eine hohe Diagnosegenauigkeit trotz einer geringen Datenbasis erreicht werden kann. Ebenso können gleichzeitig auftretende Fehler und Fehler, zu denen keine historischen Aufzeichnungen existieren, erkannt werden, wozu signalbasierte Verfahren nicht in der Lage sind. In der Regel benötigt der verwendete Ansatz viel weniger historische Daten als vergleichbare signalbasierte Verfahren wie neuronale Netze.

Der Modellierungsaufwand ist vor allem dadurch geringer, dass die Modellparameter nicht exakt gemessen, berechnet oder auf andere Weise bestimmt werden müssen. Stattdessen reicht es, ungenaue Initialschätzungen in der richtigen Größenordnung zu setzen. Über wenige Trainingsiterationen mit Messdaten werden dann sehr genaue Prozessparameter gefunden. Zugleich ist Infer.NET auf Zufallsvariablen spezialisiert, weswegen keine zusätzliche Modellierung von Messungenauigkeiten notwendig ist wie in anderen Verfahren. Die Erkennung von neuartigen oder Mehrfachfehlern wird dadurch ermöglicht, dass alle möglichen Fehlzustände in der Modellierung einbezogen werden. Für unbekannte Fehler kann eine eigene Kategorie programmiert werden. Der Ansatz benötigt weniger historische Daten als Verfahren des maschinellen Lernens, da er weniger Freiheitsgrade besitzt, zu denen häufig gute Näherungen bestimmt werden können.

In diesem Dokument sind folgende Veröffentlichungen zitiert:

[1.] M. Sayed-Mouchaweh, Hrsg., Fault Diagnosis of Hybrid Dynamic and Complex Systems, Douai: Springer International Publishing AG, 2018

[2.] S. X. Ding, Model-based Fault Diagnosis Techniques, Duisburg: Springer-Verlag Berlin Heidelberg, 2008

[3.] G. Niu, Data-Driven Technology for Engineering Systems Health Management, Shanghai: Springer Nature, 2017

[4.] C. Aldrich und L. Auret, Unsupervised Process Monitoring and Fault Diagnosis with Machine Learning Methods, Stellenbosch: Springer London Heidelberg New York Dordrecht, 2013

[5.) R. Isermann, Fault-Diagnosis Systems, Darmstadt: Springer-Verlag Berlin Heidelberg, 2006

[6.] C. Aldrich und L. Auret, Unsupervised Process Monitoring and Fault Diagnosis with Machine Learning Methods, Stellenbosch: Springer London Heidelberg New York Dordrecht, 2013

**Patentansprüche**

1. Verfahren zur Fehlerursachenanalyse in einer prozesstechnischen Anlage (1), wobei Engineering-Informationen (18) der Anlage (1), welche Informationen über die Anlagenkomponenten und ihre Verschaltung in der Anlage (1) beinhalten, in digitaler Form bereitgestellt werden, aus den Engineering-Informationen (18) ein Inferenzmodell (30) in Form eines probabilistischen physikalischen Modells der Anlage (1) mit Wahrscheinlichkeitsverteilungen und Priorvariablen erstellt wird und in einem Diagnosemodus (40) des Inferenzmodells (30) unter Verwendung von Messdaten aus der Anlage (1) eine Bayes'sche Inferenz von Fehlerwahrscheinlichkeiten durchgeführt wird.

2. Verfahren nach Anspruch 1, **dadurch gekennzeichnet, dass** in einem Trainingsmodus (39) des Inferenzmodells (30) unter Verwendung von Messdaten aus der Anlage (1), eine Bayes'sche Inferenz des Inferenzmodells (30) durchgeführt wird, wobei Schätzungen von Modellparametern, welche Prioren in dem Inferenzmodell (30) darstellen, optimiert werden.

3. Verfahren nach Anspruch 1 oder 2, **dadurch gekennzeichnet, dass** das Inferenzmodell (30) mithilfe eines Bondgraphen aus den Engineering-Informationen (18) erstellt wird.

4. Verfahren nach Anspruch 1, 2 oder 3, **dadurch gekennzeichnet, dass** aus den Engineering-Informationen der Anlage (1), insbesondere einem R&I-Fließschema (18), zunächst ein Metamodell (35) der Anlage (1) generiert wird, indem Templates (36) einer Modellbibliothek übernommen werden, die zu jedem Komponententyp der Anlage (1) den zu generierenden Code und Inferenzvariablen enthält, für die Bayes'sche Inferenz ausgeführt werden soll, und dass aus dem Metamodell das Inferenzmodell (30) der Anlage erstellt wird.

5. System zur Fehlerursachenanalyse in einer prozesstechnischen Anlage (1) mit einem Transformationsmodul (), das dazu ausgebildet ist, aus Engineering-Informationen (18) der Anlage (1), welche Informationen über die Anlagenkomponenten und ihre Verschaltung in der Anlage (1) beinhalten, ein Inferenzmodell (30) in Form eines probabilistischen physikalischen Modells der Anlage (1) mit Wahrscheinlichkeitsverteilungen und Priorvariablen zu erstellen, und mit einem Inferenzmodul (30), das dazu ausgebildet ist, in einem Diagnosemodus (40) des Inferenzmodells (30) unter Verwendung von Messdaten aus der Anlage (1) eine Bayes'sche Inferenz von Fehlerwahrscheinlichkeiten durchzuführen.

6. System nach Anspruch 5, **dadurch gekennzeichnet, dass** das Inferenzmodul (30) ferner dazu ausgebildet ist, eine Bayes'sche Inferenz des Inferenzmodells (30) durchzuführen, wobei Schätzungen von Modellparametern, welche Prioren in dem Inferenzmodell (30) darstellen, optimiert werden.

7. Computerprogrammprodukt (21), das in den Speicher eines Computers (4) geladen wird und Softwarecodeabschnitte umfasst, mit denen ein Verfahren gemäß einem der Ansprüche 1 bis 4 ausgeführt wird, wenn das Produkt auf einem Computer läuft.

FIG. 1

FIG. 2

FIG. 3

FIG. 4

A ⊢——e——↗ B

A → f → B
A ← e ← B

FIG. 5

Plant

Component A
Asset

Outlet:
Port

effort
flow

· · ·

Inlet:
Port

Component B
Asset

FIG. 6

A

■ Factor

B

FIG. 7

```
                          InferenceModule
-TrainingModel: InferenceTraining
-DiagnosisModel: InferenceDiagnosis

-InferenceParameterSet: InferenceParameters
+RunTraining(path : string, firstrow: int, lastrow : int, sampletime: int)
+RunDiagnosis(path : string, firstrow: int, lastrow : int, samplesize : int, sampletime: int)

+ImportPlantData(path : string) : bool
+ExportPlantData(path : string)
+ExportResults(path : string)
```

0..1                                                    0..1

1                                                      1

```
           InferenceTraining                                     InferenceDiagnosis
#ModelPriors: VariableArray<Gaussian>           #FaultProbs: VariableArray<double>
+CreateModel()                                   +CreateModel()
+SetPriors(priors : InferenceParameters): bool   +SetPriors(priors : InferenceParameters): bool
+Infer(measurements : Measurements) : InferenceParameters  +Infer(measurements : Measurements) : InferenceParameters
```

```
                        InferenceBase
+ModelName: string = "InferenceModel"
#InferEngine: InferenceEngine
#InferenceParameterSet: InferenceParameters
...
# Init()
# CreateModel()
+ SetPriors(priors : InferenceParameters)
+ Infer(measurements : Measurements): InferenceParameters
```

FIG. 8

| Variablentypen | Training | Diagnose |
|---|---|---|
| Konstanten<br>Naturkonstanten, Anlagendaten | konstant | konstant |
| Modellparameter<br>Beschreiben Parameter im Normalfall | Inferenz | konstant |
| Fehlerparameter<br>Beschreiben fehlerspezifische Parameter | Inferenz | Inferenz |
| Fehlertypen<br>Mit Fehlerwahrscheinlichkeit | beobachtet | Inferenz |
| Messungen<br>Mit der Angabe der Messvarianz | beobachtet | beobachtet |
| Interne Variablen<br>Aufgeteilt nach bool-, int-, double-Datentyp | verdeckt | verdeckt |

FIG. 9

Bernoulli(0.5)

A

Factor

B

Factor

C

| 1. Variante |
| --- |
| //Prior |
| Variable<bool> A = Variable Bernoulli(0.5); |
| Variable<bool> B = Variable Bernoulli(0.5); |
| Variable<bool> C = Variable Bernoulli(0.5); |

| 2. Variante |
| --- |
| //Modell |
| Variable<.ConstrainEqual(0, Variable.Factor(A) − B); |
| Variable<.ConstrainEqual(0, Variable.Factor(B) − C); |

FIG. 10

FIG. 11

**Europäisches Patentamt**
**European Patent Office**
**Office européen des brevets**

# EUROPÄISCHER RECHERCHENBERICHT

Nummer der Anmeldung

EP 20 18 3283

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | LO C H ET AL: "Bond graph based Bayesian network for fault diagnosis", APPLIED SOFT COMPUTING, ELSEVIER, AMSTERDAM, NL, Bd. 11, Nr. 1, 1. Januar 2011 (2011-01-01), Seiten 1208-1212, XP027260650, ISSN: 1568-4946 [gefunden am 2010-03-06] | 1-3,5-7 | INV. G05B23/02 |
| A | * Seite 1208 - Seite 1211 * ----- | 4 | |
| A | US 2016/320768 A1 (ZHAO HONG [US] ET AL) 3. November 2016 (2016-11-03) * Absatz [0066] * ----- | 4 | |
| A | WO 2018/223000 A1 (ASPEN TECH INC [US]) 6. Dezember 2018 (2018-12-06) * Absatz [0006] * ----- | 1,5,7 | |

**RECHERCHIERTE SACHGEBIETE (IPC)**

G05B

Der vorliegende Recherchenbericht wurde für alle Patentansprüche erstellt

| Recherchenort | Abschlußdatum der Recherche | Prüfer |
|---|---|---|
| München | 30. November 2020 | Heiner, Christoph |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 20 18 3283

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-11-2020

| Im Recherchenbericht angeführtes Patentdokument | Datum der Veröffentlichung | Mitglied(er) der Patentfamilie | Datum der Veröffentlichung |
|---|---|---|---|
| US 2016320768 A1 | 03-11-2016 | EP 3289420 A1 | 07-03-2018 |
| | | US 2016320768 A1 | 03-11-2016 |
| | | US 2018299862 A1 | 18-10-2018 |
| | | WO 2016178955 A1 | 10-11-2016 |
| WO 2018223000 A1 | 06-12-2018 | EP 3635493 A1 | 15-04-2020 |
| | | JP 2020522800 A | 30-07-2020 |
| | | US 2018348717 A1 | 06-12-2018 |
| | | WO 2018223000 A1 | 06-12-2018 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Fault Diagnosis of Hybrid Dynamic and Complex Systems. Springer International Publishing AG, 2018
- **S. X. DING.** Model-based Fault Diagnosis Techniques. Springer-Verlag Berlin, 2008
- Data-Driven Technology for Engineering Systems Health Management. **G. NIU.** Nature. Springer, 2017
- **C. ALDRICH ; L. AURET.** Unsupervised Process Monitoring and Fault Diagnosis with Machine Learning Methods. Springer, 2013
- **R. ISERMANN.** Fault-Diagnosis Systems. Springer-Verlag, 2006